# EUROPEAN PATENT SPECIFICATION

(11) **EP 0 438 742 B1**
(45) Date of publication and mention of the grant of the patent: **10.04.1996**
(21) Application number: 90124878.1
(22) Date of filing: 20.12.1990
(51) Int. Cl.: G06K 19/06, H01L 23/498, H01L 23/48

(54) **Method of fabricating a semiconductor device of thin package type**
Herstellungsverfahren von einer Halbleitervorrichtung in flacher Einkapselung
Méthode de fabrication d'un dispositif semiconducteur à encapsulation plate

(30) Priority: 22.12.1989 JP 331028/89
(43) Date of publication of application: 31.07.1991
(73) Proprietor: Oki Electric Industry Company, Limited, Tokyo 105 (JP)
(72) Inventor: Yamaguchi, Tadashi, c/o Oki Electric Ind. Co. Ltd., Minato-ku, Tokyo (JP)
(74) Representative: Betten, Jürgen, Dipl.-Ing.

(56) References cited:
- EP-A- 0 297 991
- DE-A- 2 942 397
- GB-A- 2 035 701
- US-A- 3 778 887
- US-A- 4 860 087
- PATENT ABSTRACTS OF JAPAN vol. 10, no. 149 (P- 461)(2206), 30 May 1986; & JP - A - 61003288 (TOSHIBA) 09.01.1986

## Description

### FIELD OF THE INVENTION

The present invention relates to a method of fabrication of a semiconductor device of a thin package type used in IC cards or the like.

### BACKGROUND OF THE INVENTION

Semiconductor integrated circuits which are used in watches, cameras, IC cards and the like are required to be of a packaged construction which is as thin as 0.5 to 2mm.

An example of a prior art semiconductor device having a thin package construction is shown for example in JP-A-55-56647. This is a so-called chip-on-board (COB) member in which a semiconductor element such as a semiconductor integrated circuit is directly mounted on a printed circuit board (PCB) formed for example of glass epoxy resin, and metal conductors on the PCB are connected by wire and sealing by epoxy resin or the like is made.

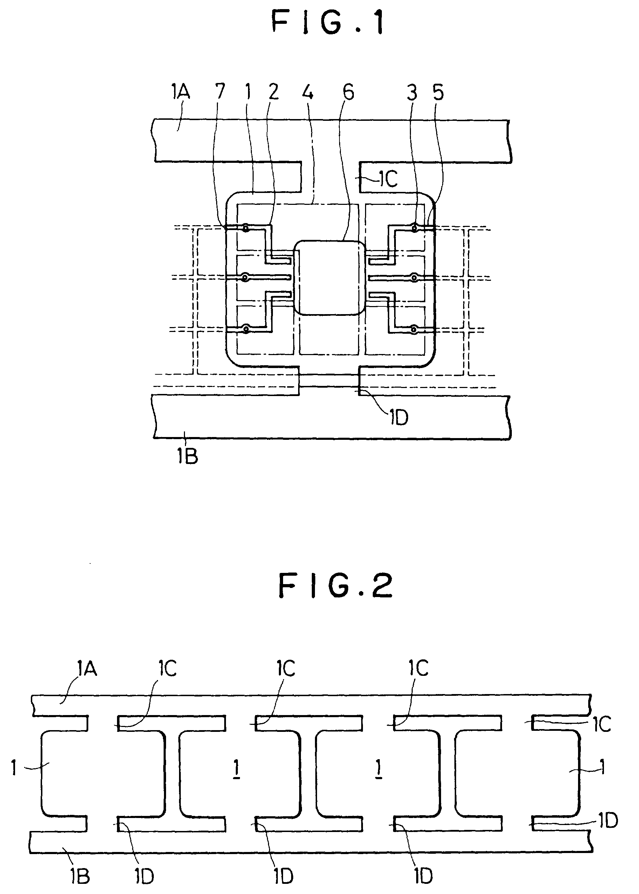

The structure of the prior art semiconductor device with the thin package construction is illustrated in Fig. 1.

In Fig. 1, reference numeral 1 denotes a PCB formed for example of glass epoxy resin. The illustrated PCB is part of a row of PCBs which are connected by a pair of ribbon parts 1A, 1B and pairs of bridging parts 1C and 1D for the respective PCBs 1, as illustrated in Fig. 2.

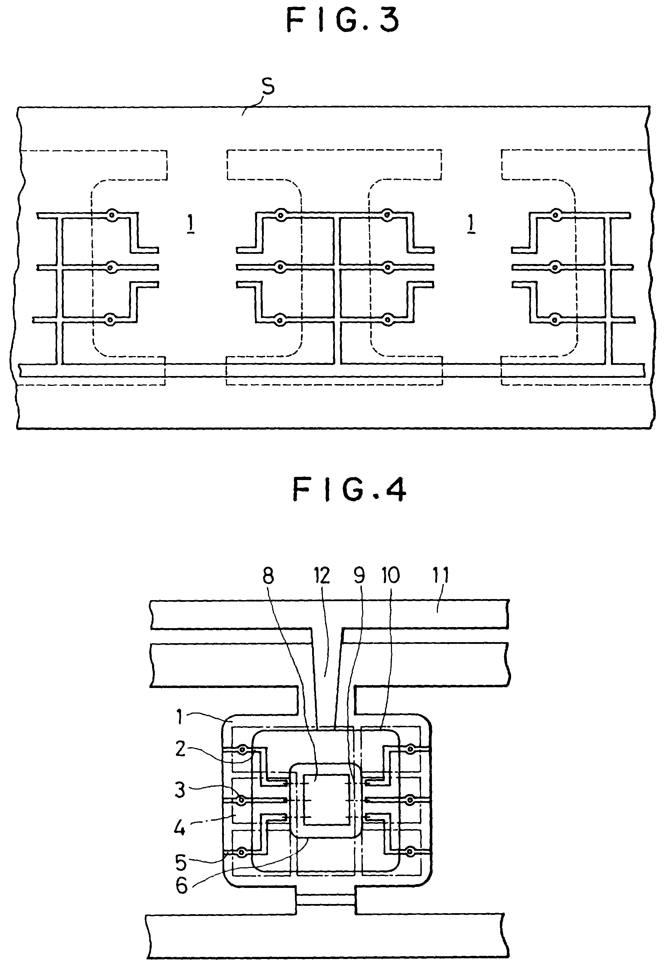

Such a row of PCBs is formed in the following manner. First, a band-shaped board member S formed for example of glass epoxy is provided, as shown in fig. 3. A conductive pattern comprising circuit leads 2 and plating leads 5 is formed on the front surface of the board member S, and is connected via throughholes 3 to a terminal pattern 4 formed on the rear surface. The conductive pattern is formed by removing, by means of etching or the like, unnecessary parts of the metal thin film (e.g. of copper) that has been previously stuck to the front surface of the board member S. and applying electroplating of Ni, Au or the like on the surface using the plating leads 5 for conduction of electric current. Thereafter, drilling or other processing technique is used to form a spot-faced part 6 for mounting the semiconductor element. Then, stamp-press or other method is used to obtain the combination of the row of PCBs 1, the ribbon parts 1A and 1B, and bridging parts 1C and 1D, as shown in fig. 2.

Plating leads (shown by broken line) are partially removed together with the unnecessary part (which will not become part of the PCBs) of the board member S. At the cut parts 7 of the plating leads at the edge of the PCB 1, a metal thin film which is not covered with any plating layer is exposed.

Then, as shown in Fig. 4, a semiconductor element 8 is bonded by adhesive material to a predetermined position of the spot-faced part 6 on the PCB 1, and wires 9 are used for connecting the circuit leads 2 with the pads on the semi conductor element 8.

Subsequently, a transfer mold or other means is used for sealing and shaping with a sealing resin 10. During this transfer molding, a die, not shown, is placed over the PCBs and a runner 11 (Fig. 4), which will be described later. Then, press-cutting or the like is used for separating each PCB from the bridging parts and the ribbon parts, to obtain a module. In Fig. 4, the state after the transfer molding and before the subsequent separation into individual modules is shown. The runner 11 and the above described die form the flow path for the sealing resin 10. A gate serving as a flow inlet to sealing part is also illustrated.

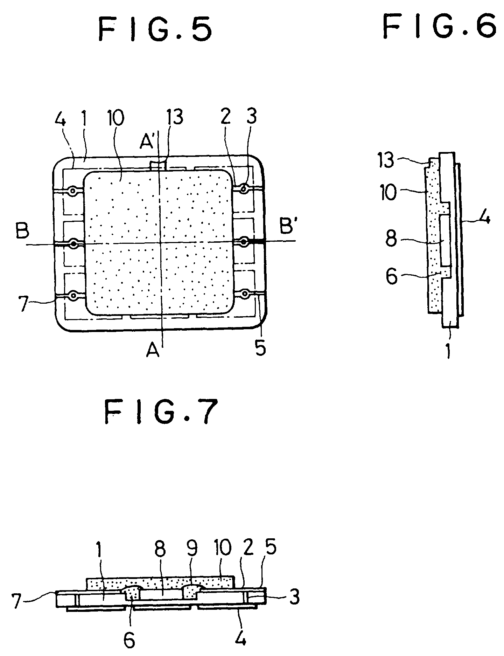

Fig. 5 shows the completed product after the separation into individual units (modules) . Fig. 6 and Fig. 7 show sections along line A-A' and B-B' in Fig. 5. In the figures, 1 denotes the PCB, 2 denotes the circuit lead, 3 denotes the throughhole, 4 denotes the terminal pattern, 5 denotes the plating lead, 6 denotes the spot-faced part, 7 denotes the plating lead cut part, 8 denotes the semiconductor element, 9 denotes the wire, and 10 denotes the sealing resin. 13 denotes the gate remainder which results after removal of the runner and the gate.

In the device of the above structure, during the processing of the board member S into the combination as shown in fig. 2, the metal thin film which is not covered with a plating layer as a protective film is exposed at the part where the plating lead is cut, and since the metal thin film is formed of Cu which is easily attacked by corrosive material often present in the environment, and the metal thin film is corroded or otherwise becomes unsuitable after use over years.

Moreover, a gate remainder may result in the vicinity of the inlet of the sealing material when the runner and the gate are removed after the sealing with resin, and such a gate remainder may cause adverse effects when the device is built in a very thin package of, for instance, a card.

### SUMMARY OF THE INVENTION

An object of the invention is to solve the problem of the exposure of the metal thin film which is easily corroded, and the gate remainder which results in the vicinity of the inlet for the sealing material, and provide a device which is highly reliable, and a method of easy fabrication of the same.

A method of fabrication of a semiconductor device according to the present invention is defined in claim 1.

In case of the semiconductor devices fabricated according to the invention, the second ends of the leads are collectively provided at a part along the circumference of the PCB, so that the ends of the lead are easily sealed by the sealing member, and their corrosion is prevented. Moreover, when the conductive pattern in the branch area is removed to isolate the individual lead elements from each other, the surface part of the support member in the branch area can be also removed to form a groove, and this groove can be utilized as an inlet for the sealing material or for the exhaustion of air during sealing. The gate remainder which is formed of the sealing material is cut away and removed, during separation into individual modules, and a semiconductor device of a desirable shape is obtained. Moreover, there will be no adverse effect when the device is built in a very thin package such as the one for a card.

### BRIEF DESCRIPTION OF THE DRAWINGS

Fig. 1 is a plan view for explaining the prior art semiconductor device.

Fig. 2 shows a combination of the PCBs, ribbon parts and bridging parts.

Fig. 3 shows a board member prior to processing into the combination shown in Fig. 2.

Fig. 4 and Fig. 5 are further plan views for explaining the prior art semiconductor device.

Fig. 6 and Fig. 7 are sectional views of the semiconductor device shown in Fig. 5.

Fig. 8 is a plan view of the semiconductor device for explaining the embodiment of the invention.

Fig. 9 shows a combination of the PCBs, ribbon parts and bridging parts.

Fig. 10 shows a board member prior to processing into the combination shown in Fig. 9.

Fig. 11 and Fig. 12 are further plan views of the semiconductor device for explaining the embodiment of the invention.

Fig. 13 and Fig. 14 are sectional views of the semiconductor device shown in Fig. 12.

### DETAILED DESCRIPTION OF THE PREFERRED EMBODIMENTS

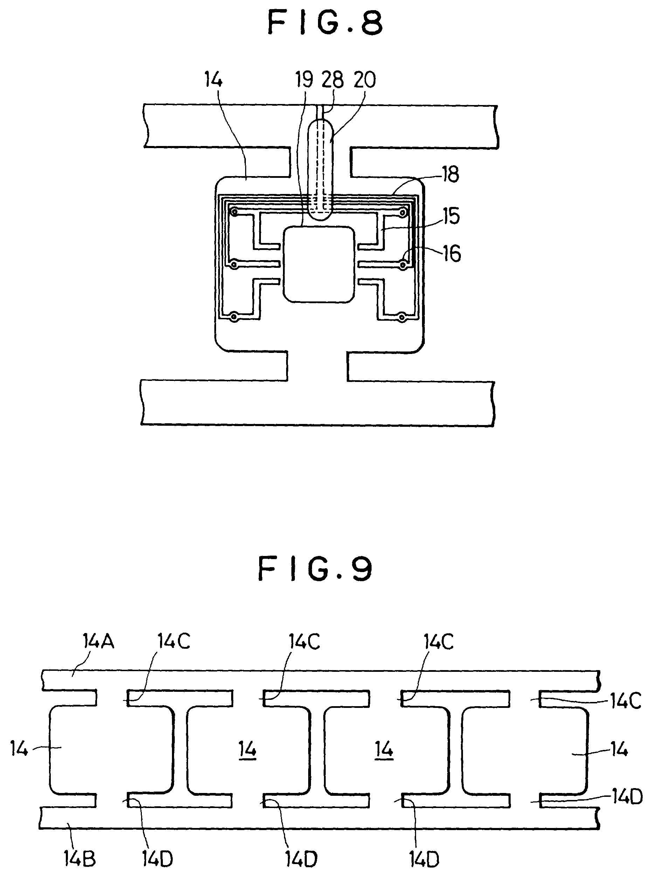

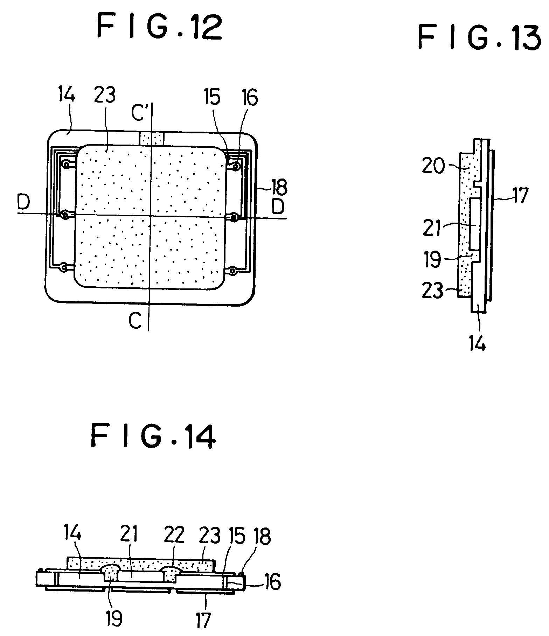

Fig. 8, Fig. 11 and 12 are plan views of the semiconductor device for explaining the embodiment of the invention. Fig. 13 and Fig. 14 are sectional views of the semiconductor device of Fig. 12. Description will now be made with reference to the drawings.

In Fig. 8, 14 denotes a PCB as a semiconductor element supporting member formed of glass epoxy or the like. The illustrated PCB is part of a row of PCBs which are connected by a pair of ribbon parts 14A, 14B and bridging parts 14C and 14D for the respective PCBs 14, as illustrated in Fig. 9.

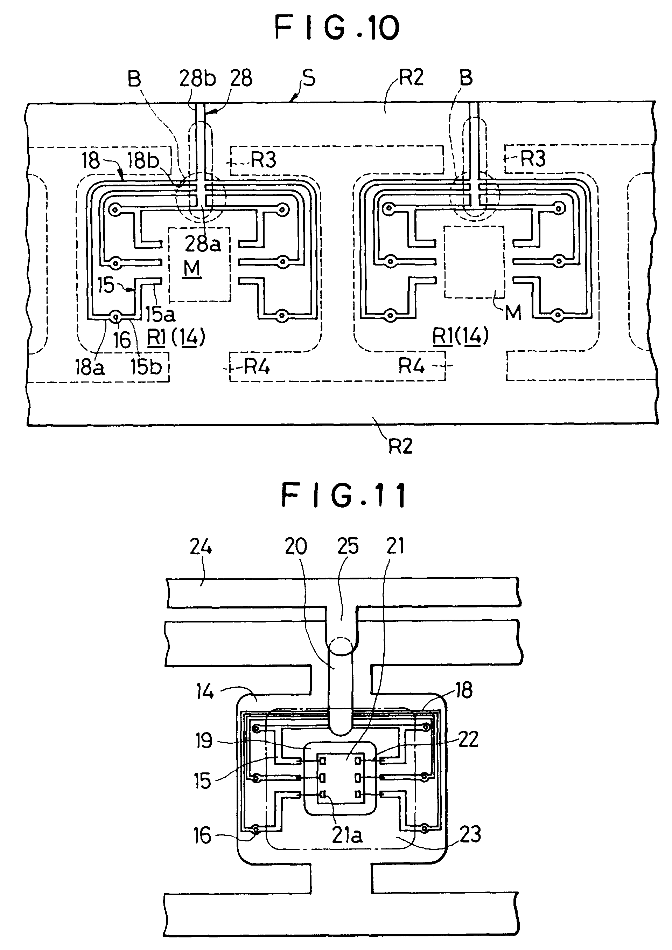

Such a row of PCBs is formed in the following manner. First, a glass epoxy film or some other band-shaped board member S shown in Fig. 10 is provided. The board member includes first regions R1 which will be a row of supporting members, second regions R2 which will be ribbon parts extending parallel with each other, and third regions R3 which will be pairs of bridging parts for the respective supporting members 14 and bridging the corresponding supporting member 14 to said pair of ribbon parts. Each of the first regions R1 is formed of a PCB and has a mount region M on which a semiconductor element having pads will be mounted.

Formed on each PCB 14 is a conductive pattern comprising a plurality of circuit leads 15 having first ends 15a positioned near the mount region M (for connection with the semiconductor element to be described later) having second ends 15b connected via respective throughholes 16 to a terminal pattern 17 formed on the rear surface of the PCB. the conductive pattern also comprises a common plating lead 28 having a first end 28a positioned in a branch area B, extending through the second region R3 and across the third region R3, and having a second end 28b positioned at the edge of the third region R3. The conductive pattern further comprises individual plating leads 18 provided for the respective circuit leads 15, having first ends 18a connected to respective throughholes 16, and second ends 18b collected in the branch area B, and connected to the first end 28a of the common plating lead 28 in the branch area B.

The conductive pattern is formed by selectively removing, by etching or other processing, unnecessary parts of thin film of metal such as Cu that has been previously stuck to the surface of the PCB 14. The conductive pattern is covered with gold or like protective film for anticorrosion, by means of electroplating, using the plating leads 18 and 28 for conduction of electric current for the plating.

Conventionally, the plating leads were extended in any directions of the PCB, whereas in the present embodiment, the individual plating leads 18 for all the circuit leads 15 are collected in a branch area B and connected to the common plating lead 28. The second ends 18b of the individual leads 18 are collected in a region which will be sealed by a resin to be described later. The second end 28b of the common plating lead 28 is outside of the region which will be sealed by the resin.

After the plating of the conductive patterns 15, a spot-faced part 19 is formed by drilling or other processing, and by a similar processing, a groove 20 is formed. The groove 20 extends from the branch area B across the bridging region R3 and toward the edge ribbon part R2. The groove 20 cuts and isolates the plating leads 18 and 28 and also serves as a path for the injection of the sealing resin or exhaustion of air during transfer molding is formed on the surface of the PCB 14. Then, stamp-press or other means is used to obtain the combination of the row of PCBs 14, the ribbon parts 14A and 14B, and bridging parts 14C and 14D, as shown in Fig. 9.

Subsequently, as shown in Fig. 11, a semiconductor element 21 is fixed, by means of an adhesive or the like, at a predetermined position of the spot-faced part 19 on the PCB 14, and output pads 21a of the semiconductor element 21 and the first ends 15a of the circuit leads 15 are connected with wires 22.

Then, by means of the transfer molding or other processing, molding of the sealing member of sealing resin 23 is performed, using the groove for injection of the resin or for exhaustion of air. During the transfer molding, a die, not shown, is placed over the semiconductor element 21, the groove 20, and the runner 24. When the sealing resin 21 is injected through the runner 24 and the groove 20, an outlet for the air exhaustion is provided in the die. When the groove 30 is used for the air exhaustion, an inlet for the injection of the sealing resin 21 is provided in the die. Then, by means of press cutting or other processing, separation into individual modules is achieved.

Fig. 11 shows the state after the transfer molding and before the subsequent separation into individual modules. A runner 24 and a gate 25 forming the path of injection for the sealing resin 23 are illustrated. The gate 25 is not in contact with the sealing member as in the prior art, but is partially overlapping the groove 20. Therefore, when the runner 24 and the gate 25 are removed, and a gate remainder is left, but it is in a part which will be removed when separation into individual modules is performed. Moreover, the cut part of the plating lead 18 is completely covered with the sealing resin 23. The problems of the gate remainder and the exposure of the cut parts of Cu of the plating leads 18 which were problematical with the prior art are therefore eliminated.

Fig. 13 and Fig. 14 are sectional views along lines C-C' and D-D', respectively, in Fig. 12. 14 denotes a PCB, 15 denotes a conductive pattern, 16 denotes a throughhole, 17 denotes a terminal pattern, 18 denotes a plating lead, 19 denotes a spot-faced part, 20 denotes a groove, 21 denotes a semiconductor element, 22 denotes a wire, and 23 denotes a sealing resin.

As has been described, according to the embodiment of the invention, the conductive pattern comprising the circuit leads 15 and plating leads 18 and 28 are formed of a metal thin film which is easy to corrode and an overlying plating layer formed using the leads 18 arid 28 as plating leads, and the parts of the plating leads 18 and 28 connected in the branch area is removed to isolate the leads 18 and 28 from each other, and the cut parts are sealed with sealing resin 23, so the metal thin film which is easily corroded is completely sealed with the sealing resin, so corrosion which may otherwise start with the cut surface of the plating lead 18 is prevented. Moreover, the groove is provided in the branch area B of the board member S, and sealing resin 23 is formed to fill the groove. Thus, unnecessary resin projecting at the semiconductor device surface is avoided and a semiconductor device with a good shape is obtained. Moreover, simultaneously with the removal of the leads in the branch area B, a groove 20 is formed to extend through the branch area B, and is utilized for injection of the sealing resin or exhaustion of air during transfer molding, and the gate remainder is cut and removed together with the unnecessary part 14 of the board member S. A semiconductor device which does not have unnecessary projecting gate remainder is easily obtained.

In the embodiment described, only one common plating lead is provided for each module. But, there may be a plurality of common plating leads for each module. In such a case, the individual plating leads are divided into the same number of groups as the common plating leads, and the individual plating leads of each group are connected to one of the common plating leads.

## Claims

1. A method of fabrication of a semiconductor device comprising the steps of:
providing a board member (S) having first regions (R1) which will be a row of supporting members (14), second regions (R2) which will be a pair of ribbon parts (14A,14B) extending parallel with each other, and third regions (R3,R4) which will be pairs of bridging parts (14C,14D) for the respective supporting members (14) and bridging the corresponding supporting members (14) to said pair of ribbon parts (14A,14B), said first regions (R1) each having a mount region (M) on which a semiconductor element (21) having pads (21a) will be mounted;
forming on each of said first regions (R1) a conductive pattern (15,18,28) comprising individual lead elements (15,18) having first ends (15a) positioned near said mount region (M) and second ends;
electroplating a protective film over said conductive pattern (15,18,28);
mounting the semiconductor element (21) on said mount region (M) in each said first region;
connecting said first ends (15a) of said leads (15,18) and said pads (21a) of said semiconductor element (21) by means of conductors (22); and
sealing said semiconductor element (21) and said conductor (22) by means of a sealing material (23);
characterized in that
said second ends (18b) of individual lead elements (15,18) are commonly connected to a first end (28a) of a common plating lead element (28) extending through one of the corresponding bridging parts (14C,14D);
said step of electroplating is performed using said common plating lead element (28) as a plating lead; and
said method further comprises the step of removing part of the individual lead elements (18) and said common lead element (28) to isolate the individual lead elements (15,18) from each other, whereby after removal of the common lead element (28) a groove (20) remains which is used in said sealing step.

2. The method of claim 1, further comprising the step of:
forming, from said board member, a combination of said row of supporting members (14), said pair of ribbon parts (14a,14b), and said bridging parts (14C,14D), by removing parts of said board member;
wherein said step of sealing is performed after said step of forming said combination.

3. The method of claim 2, wherein said step of forming said combination comprises a stamp-pressing.

4. Tire method of claim 1, further comprising the step of separating each supporting member (14) after said step of sealing thereby to produce a packaged module.

5. The method of claim 1, further comprising the step of removing the surface part of the supporting member to form a groove (20) in said supporting member (14).

6. The method of claim 5, wherein said step of removing the surface part of said supporting member (14) and said step of removing said parts of said individual lead elements (18) and said common plating elements (28) are performed simultaneously.

7. The method of claim 5, wherein in said step of sealing by means of said sealing material (23), injection of the sealing material (23) or air exhaustion is made through said groove (20) formed on said supporting member (14).

## Patentansprüche

1. Verfahren zur Herstellung eines Halbleiterbauelements mit den Schritten:
Vorsehen eines Plattenelements (S) mit ersten Bereichen (R1), die eine Reihe von Halteelementen (14) sein werden, zweiten Bereichen (R2), die ein Paar von sich parallel zueinander erstreckenden Bandteilen (14A, 14B) sein werden, und dritten Bereichen (R3, R4), die Paare von Brückenteilen (14C, 14D) für die jeweiligen Halteelemente (14) darstellen und die entsprechenden Halteelemente (14) mit dem Paar von Bandteilen (14A, 14B) brückenartig verbinden werden, wobei die ersten Bereiche (R1) jeweils einen Montagebereich (M) aufweisen, auf dem ein Halbleiterelement (21) mit Anschlußflächen (21a) montiert werden wird;
auf jedem der ersten Bereiche (R1) Bilden eines Leitungsmusters (15, 18, 28) mit einzelnen Leitungselementen (15, 18) mit in der Nähe des Montagebereiches (M) angeordneten ersten Enden (15a) und zweiten Enden;
galvanisches Metallisieren eines Schutzfilms über das Leitungsmuster (15, 18, 28);
Montieren des Halbleiterelements (21) auf dem Montagebereich (M) in jedem ersten Bereich;
Verbinden der ersten Enden (15a) der Leitungen (15, 18) und der Anschlußflächen (21a) des Halbleiterelements (21) mit Hilfe von Leitern (22); und
Versiegeln des Halbleiterelements (21) und der Leiter (22) mit Hilfe eines Versiegelungsmaterials (23);
dadurch gekennzeichnet, daß
die zweiten Enden (18b) der einzelnen Leitungselemente (15, 18) gemeinsam mit einem ersten Ende (28a) in eines sich durch einen der entsprechenden Brückenteile (14C, 14D) erstreckenden gemeinsamen Metallisierungsleitungselements (28) verbunden sind;
der Schritt der galvanischen Metallisierung unter Verwendung des gemeinsamen Metallisierungsleitungselements (28) als Metallisierungsleitung durchgeführt wird; und
das Verfahren ferner die Schritte aufweist
Entfernen eines Teils der einzelnen Leitungselemente (18) und des gemeinsamen Leitungselements (28) zum Isolieren der einzelnen Leitungselemente (15, 18) voneinander, wodurch nach der Entfernung des gemeinsamen Leitungselements (28) eine Ausnehmung (20) verbleibt, die bei dem Versiegelungsschritt verwendet wird.

2. Verfahren nach Anspruch 1, ferner mit dem Schritt:
aus dem Plattenelement Bilden einer Kombination der Reihe von Halteelementen (14), des Paares von Bandteilen (14A, 14B) und der Brückenteile (14C, 14D), durch Entfernen von Teilen des Plattenelements;
wobei der Schritt der Versiegelung nach dem Schritt des Bildens der Kombination durchgeführt wird.

3. Verfahren nach Anspruch 2, bei dem Schritt des Bildens der Kombination ein Stanzpressen beinhaltet.

4. Verfahren nach Anspruch 1, ferner mit dem Schritt des Trennens jedes Halteelements (14) nach dem Schritt der Versiegelung, um dadurch ein montiertes Modul zu erzeugen.

5. Verfahren nach Anspruch 1, ferner mit dem Schritt des Entfernens des Oberflächenteils des Halteelements, um in dem Halteelement (14) eine Ausnehmung (20) zu bilden.

6. Verfahren nach Anspruch 5, bei dem der Schritt der Entfernung des Oberflachenteils des Halteelements (14) und der Schritt der Entfernung der Teile der einzelnen Leitungselemente (18) und der gemeinsamen Metallisierungselemente (28) gleichzeitig durchgeführt werden.

7. Verfahren nach Anspruch 5, bei dem bei dem Schritt der Versiegelung mit Hilfe des Versiegelungsmaterials (23) das Einführen des Versiegelungsmaterials (23) oder das Ausstoßen von Luft durch die auf dem Halteelement (14) gebildete Ausnehmung (20) geschieht.

## Revendications

1. Procédé de fabrication d'un dispositif à semi-conducteur, comportant les étapes consistant à :
fournir un élément (S) formant plaquette, comportant des premières zones (R1) qui constitueront une rangée d'éléments de support (14), des deuxièmes zones (R2) qui constitueront deux parties (14A, 14B) formant ruban, s'étendant parallèlement l'une à l'autre, et des troisièmes zones (R3, R4) qui constitueront deux parties de liaison (14C, 14D) pour les éléments de support respectifs (14), reliant les éléments de support correspondants (14) auxdites deux parties (14A, 14B) formant ruban, lesdites premières zones (R1) comportant chacune une zone de montage (M) sur laquelle est monté un composant à semi-conducteur (21) ayant des plages de contact (21a),
former sur chacune desdites premières zones (R1) un réseau de conducteurs (15, 18, 28) constitué d'éléments de connexion individuels (15, 18), ayant chacun une première extrémité (15a) positionnée à proximité de ladite zone de montage (M) et une seconde extrémité,
former par électrodéposition un film protecteur sur ledit réseau de conducteurs (15, 18, 28),
monter le composant à semi-conducteur (21) sur ladite zone de montage (M) de chacune desdites premières zones,
relier lesdites premières extrémités (15a) desdits éléments de connexion (15, 18) et lesdites plages de contact (21a) dudit composant à semi-conducteur (21) par l'intermédiaire de conducteurs (22), et
Sceller ledit composant à semi-conducteur (21) et lesdits conducteurs (22) à l'aide d'un matériau de scellage (23) ,
caractérisé en ce que
lesdites secondes extrémités (18b) des éléments de connexion individuels (15, 18) sont reliées en commun à une première extrémité (28a) d'un élément de connexion metallisé commun (28), s'étendant à travers l'une des parties de liaison correspondantes (14C, 14D),
ladite étape d'électrodéposition est effectuée en utilisant ledit élément de connexion métallisé commun (28) en tant que conducteur métallisé, et
ledit procédé comportant en outre l'étape consistant à
enlever une partie des éléments de connexion individuels (18) et dudit élément de connexion commun (28) pour isoler les éléments de connexion individuels (15, 18) les uns des autres, de sorte qu'après l'enlèvement de l'élément de connexion commun (28) subsiste une gorge (20), laquelle est utilisée dans ladite étape de scellage.

2. Procédé selon la revendication 1, comportant en outre l'étape consistant à :
former, à partir dudit élément formant plaquette, une combinaison constituée de ladite rangée d'éléments de support (14), desdites deux parties (14a, 14b) formant ruban, et desdites parties de liaison (14C, 14D), en enlevant des parties dudit élément formant plaquette,
dans lequel ladite étape de scellage est effectuée après ladite étape consistant à former ladite combinaison.

3. Procédé selon la revendication 2, dans lequel ladite étape consistant à former ladite combinaison comporte un estampage.

4. Procédé selon la revendication 1, comportant en outre l'étape consistant à séparer chaque élément de support (14), après ladite étape de scellage, afin de produire un module encapsulé.

5. Procédé selon la revendication 1, comportant en outre l'étape consistant à enlever une partie superficielle de l'élément de support pour former une gorge (20) dans ledit élément de support (14).

6. Procédé selon la revendication 5, dans lequel ladite étape consistant à enlever une partie superficielle dudit élément de support (14) et ladite étape consistant à enlever lesdites parties constituées desdits éléments de connexion individuels (18) et desdits éléments métallisés communs (28) sont effectuées de manière simultanée.

7. Procédé selon la revendication 5, dans lequel, pendant ladite étape de scellage effectuée à l'aide dudit matériau de scellage (23), une injection de matériau de scellage (23), ou un refoulement d'air, s'effectue à travers ladite gorge (20) formée sur ledit élément de support (14).
